# EUROPEAN PATENT APPLICATION

(11) **EP 3 808 699 A1**
(43) Date of publication of application: **21.04.2021**
(21) Application number: 19818793.2
(22) Date of filing: 22.05.2019
(51) Int. Cl.: B81C 3/00, B81B 3/00, H01L 23/02, H01L 23/08

(54) **METHOD FOR MANUFACTURING MEMS DEVICE, AND MEMS DEVICE**

(30) Priority: 13.06.2018 JP 2018112531
(71) Applicant: Tohoku University, Sendai-shi, Miyagi 980-8577 (JP)
(72) Inventor: SUZUKI, Yukio, Sendai-shi, Miyagi 980-8577 (JP); TANAKA, Shuji, Sendai-shi, Miyagi 980-8577 (JP); TSUKAMOTO, Takashiro, Sendai-shi, Miyagi 980-8577 (JP)
(74) Representative: Plougmann Vingtoft a/s
(86) International application number: PCT/JP2019/020225
(87) International publication number: WO 2019/239829

(57) **Abstract**

AMEMS device manufacturing method and a MEMS device are provided which can enhance a degree of vacuum inside an operation space and reduce the installation cost and maintenance cost of a manufacturing apparatus as well as manufacturing cost. A MEMS device includes a MEMS device wafer 11 having an operation element 21 formed on a Si substrate 11a, and a CAP wafer 12 provided to cover the MEMS device wafer 11 to form an operation space 13 for operably accommodating the operation element 21. The CAP wafer 12 is made of silicon and includes vent holes 23 formed to communicate with the operation space 13. The operation space 13 is sealed by performing a heat treatment in a hydrogen gas atmosphere to close the vent holes 23 by silicon surface migration of the CAP wafer 12 with the CAP wafer 12 and the MEMS device wafer 11 bonded.

## Description

### Field of the Invention

The present invention relates to a method for manufacturing a MEMS device, and a MEMS device.

### Description of Related Art

In recent years, gyroscopes as measuring instruments for electrically detecting a posture, an angular velocity or an angular acceleration of an object, timing resonator MEMS oscillators composed of a MEMS vibrator and an analog oscillation circuit, IR sensors as measuring instruments for electrically detecting infrared rays and the like have been developed as devices utilizing micro-electromechanical systems (MEMS) (hereinafter, also referred to as "MEMS devices").

These MEMS devices can operate with high performance by being vacuum-sealing packaged. Various packaging modes have been proposed as vacuum sealing packaging. For example, a known timing resonator MEMS oscillator is such that a CAP substrate formed by a silicon substrate is bonded to a silicon substrate forming a vibrating plate as an operation element to seal the MEMS oscillator while forming an operation space for the vibrating plate (see, for example, patent literature 1). In this MEMS oscillator, the operation space is sealed in a vacuum atmosphere of 100 Pa or lower to maintain a high Q-value of a vibrator.

A wafer level packaging technique, a so-called episeal technique, has been developed as a method for vacuum-sealing a MEMS device (see, for example, patent literature 2 or 3). In this method, a vent hole penetrating in a thickness direction is first formed in a CAP wafer made of a silicon substrate or polysilicon, and the CAP wafer is bonded to a MEMS device wafer in a state where an operation space, which does not obstruct a movement of an operation element of the MEMS device, is formed. Thereafter, vapor-phase growth deposition is carried out by combining a thermal decomposition and a chemical reaction under a high temperature, using a small amount of SiH₂Cl₂ dichlorosilane, HSiCl₃ trichlorosilane or the like serving as a source gas in a H₂ atmosphere, whereby the vent hole formed in the CAP wafer is closed. Specifically, single crystalline or polycrystalline silicon is epitaxially deposited on a side wall of the vent hole of the CPA wafer to form an epitaxial silicon layer and close and pinch off the vent hole, using an epitaxial reactor. At this time, the operation space is filled with an unreacted gas when the epitaxial silicon layer is deposited. However, since H₂ having a very small atomic size substantially entirely escapes to outside by a thermal diffusion phenomenon, the operation space can be highly evacuated.

It should be noted that a method has been developed in which a plurality of holes are provided in a row in a silicon substrate, silicon surface migration is caused by performing a heat treatment at a temperature lower than a melting point of silicon, the holes are respectively closed on the surface of the silicon substrate and coupled along the surface of the silicon substrate by the surface migration to form tubular hollows in the silicon substrate. A heat treatment temperature is determined, utilizing a relationship of a diffusion coefficient of silicon atoms and the heat treatment temperature by the surface migration (see, for example, non-patent literature 1).

### Citation List

### Patent Literature

Patent Literature 1: JP-A-2016-171393
Patent Literature 2: specification of USP No. 6928879
Patent Literature 3: JP-B-5113980

### Non-Patent Literature:

Non-Patent Literature 1: Tsutomu Sato, et. al., "Fabrication of Silicon-on-Nothing Structure by Substrate Engineering Using the Empty-Space-in-Silicon Formation Technique", Jpn. J. Appl. Phys., 2004, Vol. 43, No. 1, pp. 12 to 18.

### Summary of the Invention

In the episeal technique described in patent literature 2 and 3, after the vent hole is closed to seal the operation space, H₂ of an atmosphere gas escapes from the operation space due to thermal diffusion. However, since unreacted SiH₂Cl₂ dichlorosilane, HSiCl₃ trichlorosilane or the like remains inside the operation space when the epitaxial silicon layer is deposited, there has been a problem that a degree of vacuum inside the operation space is reduced. Further, since cost is high in closing the vent hole utilizing an epitaxial growth, a large amount of a raw material gas is used and an epitaxial growth system needs to be controlled, an epitaxial apparatus becomes complicated and an epitaxial furnace itself is also expensive. Therefore, there has been also a problem of high installation cost and maintenance cost of the apparatus.

The present invention was developed, focusing on such a problem, and an object thereof is to provide a method for manufacturing a MEMS device and a MEMS device capable of enhancing a degree of vacuum inside an operation space and reducing the installation cost and maintenance cost of a manufacturing apparatus as well as manufacturing cost.

To achieve the above object, a method according to a first aspect of the present invention is a method for manufacturing a MEMS device including a MEMS device wafer having an operation element formed on a substrate, and a CAP wafer provided to cover the MEMS device wafer to form an operation space for operably accommodating the operation element, wherein the CAP wafer is made of silicon and includes a vent hole formed to communicate with the operation space, and the operation space is sealed by performing a heat treatment in a hydrogen gas atmosphere to close the vent hole by silicon surface migration of the CAP wafer with the CAP wafer and the MEMS device wafer bonded.

Further, a method according to a second aspect of the present invention is a method for manufacturing a MEMS device including a MEMS device wafer having an operation element formed on a substrate, and a CAP wafer provided to cover the MEMS device wafer to form an operation space for operably accommodating the operation element, wherein the substrate is made of silicon and includes a vent hole formed to communicate with the operation space, and the operation space is sealed by performing a heat treatment in a hydrogen gas atmosphere to close the vent hole by silicon surface migration of the substrate with the CAP wafer and the MEMS device wafer bonded.

Further, a method according to a third aspect of the present invention is a method for manufacturing a MEMS device including a MEMS device wafer having an operation element formed on a substrate, and a CAP wafer provided to cover the MEMS device wafer to form an operation space for operably accommodating the operation element, wherein a bonding part of the MEMS device wafer with the CAP wafer and/or the CAP wafer is/are made of silicon, and the operation space is sealed by performing a heat treatment in a hydrogen gas atmosphere to close a vent hole by silicon surface migration of the bonding part and/or the CAP wafer with the CAP wafer and the MEMS device wafer bonded and the vent hole communicating with the operation space formed in a bonding interface of the CAP wafer and the MEMS device wafer.

The methods according to the first to third aspects of the present invention for manufacturing a MEMS device are preferably such that a hydrogen gas flows out from the operation space due to thermal diffusion and the operation space is set in a vacuum state or a low pressure state.

The methods according to the first to third aspects of the present invention for manufacturing a MEMS device can close the vent hole communicating with the operation space and seal the operation space by utilizing the surface migration of the silicon of the CAP wafer or the silicon of the substrate of the MEMS device wafer by the heat treatment. Since a source gas for epitaxial growth or the like needs not be mixed into the hydrogen gas atmosphere at the time of the heat treatment, it is possible to prevent gases other than the hydrogen gas from remaining inside the operation space after sealing. Further, since almost all the hydrogen gas flows out to the outside of the operation space by a thermal diffusion phenomenon by performing the heat treatment in the hydrogen gas atmosphere having a sufficiently low hydrogen concentration, a degree of vacuum inside the operation space can be enhanced.

Further, the methods according to the first to third aspects of the present invention for manufacturing a MEMS device can close the vent hole only by the heat treatment, and a simple apparatus configuration can be realized since a smaller amount of a raw material gas is used and a growth system needs not be controlled as compared to conventional techniques such as an episeal technique utilizing an epitaxial growth. Thus, the installation cost and maintenance cost of a manufacturing apparatus as well as manufacturing cost can be reduced.

In the methods according to the first to third aspects of the present invention for manufacturing a MEMS device, at least a part of the vent hole preferably has such a diameter as to be closable by the surface migration. Although depending on the temperature and time of the heat treatment, that diameter is preferably 1 µm or less, more preferably 0.8 µm or less. Further, for ventilation, a diameter of the vent hole is preferably 0.1 µm or more, more preferably 0.4 µm or more. Further, the vent hole may be formed before the CAP wafer and the MEMS device wafer are bonded, or may be formed after the CAP wafer and the MEMS device wafer are bonded.

In the methods according to the first to third aspects of the present invention for manufacturing a MEMS device, the vent hole may have any shape as long as the vent hole is closable by the silicon surface migration. For example, the vent hole may be composed of an inner hole on the operation space side and an outer hole on a side opposite to the operation space, the inner and outer holes having different diameters and communicating with each other, and φ1 > φ2 or φ1 < φ2 if φ1 denotes a diameter of the inner hole and φ2 denotes a diameter of the outer hole. Further, the vent hole may have a tapered shape, and φ1 > φ2 or φ1 < φ2 if φ1 denotes a diameter on a surface on the operation space side and φ2 denotes a diameter on a surface on a side opposite to the operation space.

The methods according to the first to third aspects of the present invention for manufacturing a MEMS device are preferably such that a hydrogen gas flows out from the operation space due to thermal diffusion and the operation space is set in a low pressure state of an inert gas by performing the heat treatment in the hydrogen gas atmosphere containing the inert gas. In this case, the degree of vacuum inside the operation space can be easily adjusted by adjusting a content ratio of the inert gas. In this way, the inside of the operation space can be set to a degree of vacuum optimal for a function of the operation element. The inert gas may be any inert gas such as an Ar gas as long as the function of the operation element is not adversely affected.

In the methods according to the first to third aspects of the present invention for manufacturing a MEMS device, preferably, a heat treatment temperature of the heat treatment is 1000°C to 1150°C and a heat treatment time thereof is 10 minutes or more and 1 hour or less. In this case, the vent hole can be closed by causing the silicon surface migration without adversely thermally affecting the operation element and the like inside the operation space. The heat treatment time is more preferably 30 minutes or less.

A MEMS device according to the present invention includes a MEMS device wafer having an operation element formed on a substrate, and a CAP wafer provided to cover the MEMS device wafer to form an operation space for operably accommodating the operation element, wherein each of the MEMS device wafer and the CAP wafer is constituted by an SOI wafer or a Si wafer, and the operation space has an inner wall formed only of a material derived from the SOI wafer and/or the Si wafer and is sealed.

The MEMS device according to the present invention can be suitably manufactured by the methods according to the first to third aspects of the present invention for manufacturing a MEMS device. The MEMS device according to the present invention can have an enhanced degree of vacuum inside the operation space and be inexpensively manufactured by the methods according to the first to third aspects of the present invention for manufacturing a MEMS device. The MEMS device according to the present invention is a device such as a resonator, a gyro, a Lorentz-force magnetic sensor, an acceleration sensor, a timing resonator, an IR sensor or a pressure sensor. The MEMS device according to the present invention is preferably such that the MEMS device wafer is composed of a SOI wafer and the operation element is formed on a Si substrate of the SOI wafer.

According to the present invention, it is possible to provide a MEMS device manufacturing method and a MEMS device capable of enhancing a degree of vacuum inside an operation space and reducing the installation cost and maintenance cost of a manufacturing apparatus as well as manufacturing cost.

### Brief Description of the Drawings

FIGS. 1 are sectional views showing a MEMS device manufacturing method of an embodiment of the present invention,
FIGS. 2(a) and 2(b) are an enlarged sectional view near a vent hole of a CAP wafter before a heat treatment and an enlarged sectional view near the vent hole of the CAP wafter with the vent hole of the CAP wafer closed by silicon surface migration in the MEMS device manufacturing method shown in FIGS. 1, and
FIG. 3 is a sectional view showing a modification before the heat treatment of the MEMS device manufacturing method of the embodiment of the present invention in which the MEMS device is constituted by a timing resonator.

### Detailed Description of the Invention

Hereinafter, an embodiment of the present invention is described on the basis of the drawings.

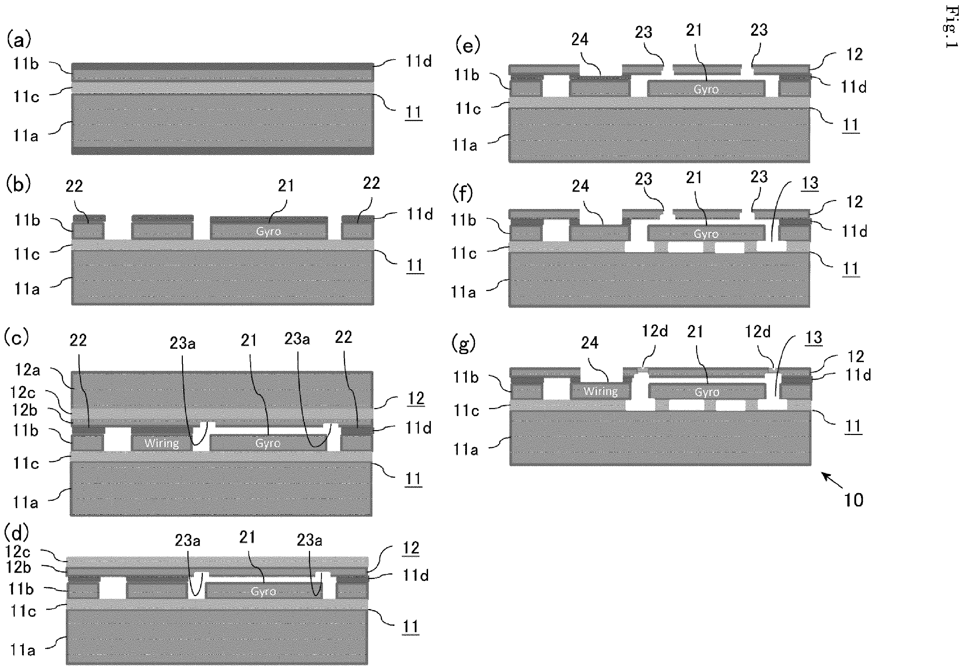

FIGS. 1 to 3 show a MEMS device manufacturing method and a MEMS device of the embodiment of the present invention.

FIGS. 1 show the MEMS device manufacturing method in which an operation element is constituted by a gyro, and the MEMS device manufacturing method of the embodiment of the present invention is described, along with an example of FIG. 1.

As shown in FIG. 1, in the MEMS device manufacturing method of the embodiment of the present invention, a SOI (Silicon on Insulator) wafer having a SiO₂ film (oxide film) 11c sandwiched between a Si substrate 11a and a Si single crystalline film 11b is first used as a MEMS device wafer 11 and a surface of the Si single crystalline film 11b is thermally oxidized to form a thermal oxide film (SiO₂ film) 11d (see FIG. 1(a)). In a specific example, a thickness of the thermal oxide film 11d is 1 µm. Subsequently, the thermal oxide film 11d and the Si single crystalline film 11b are etched to form an operation element 21 and non-movable parts 22 (see FIG. 1(b)).

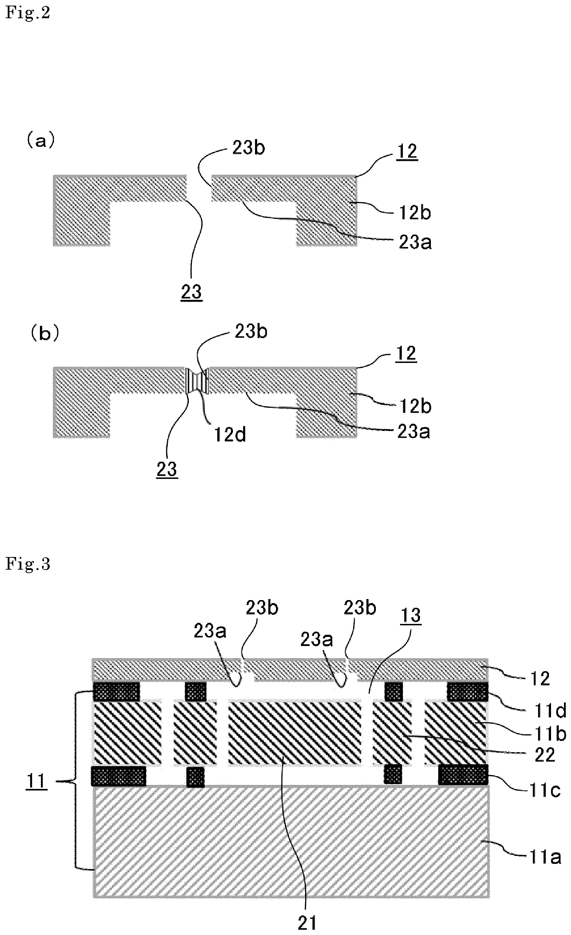

Subsequently, in a CAP wafer 12 constituted by the SOI wafer, a Si single crystalline film 12b of the CAP wafer 12 and the thermal oxide films 11d of the non-movable part 22 are bonded and integrated to cover the operation element 21 and the non-movable parts 22 of the MEMS device wafer 11 (see FIG. 1(c)). At the time of bonding, the thermal oxide film 11d on the surface of the operation element 21 is removed in advance. Further, as shown in FIG. 2(a), one or more concave cavities (inner holes) 23a are formed in the surface of the Si single crystalline film 12b of the CAP wafer 12 facing the operation element 21. In a specific example, bonding is performed by a heat treatment at 1100°C for 5 hours. Subsequently, the CAP wafer 12 is ground and thinned from the side of a Si substrate 12a (see FIG. 1(d), thereby removing the Si substrate 12a and a SiO₂ film 12c of the CAP wafer 12 and leaving only the Si single crystalline film 12b.

Subsequently, as shown in FIG. 2(a), a through hole (outer hole) 23b is formed from the surface of the CAP wafer 12 toward the concave cavity 23a to form a vent hole 23. Further, the CAP wafer 12 is etched to also form an electrode region 24 for providing an electrode (see FIG. 1(e)). In a specific example, the vent hole 23 is such that the concave cavity 23a is formed as an inner hole for the purpose of reducing a ratio of a diameter and a depth of the vent hole 23. If φ1 denotes a diameter of the inner hole and φ2 denotes a diameter of the though hole (outer hole) 23b, φ1 > φ2. The diameter φ2 of the through hole (outer hole) 23b is 1 µm or less. It should be noted that the vent hole 23 may be formed such that φ1 < φ2.

Subsequently, a part of a SiO₂ film 11c of the MEMS device wafer 11 in contact with the operation element 21 is also etched so that the operation element 21 operates (see FIG. 1(f)). In this way, an operation space 13 surrounded by the Si substrate 11a of the MEMS device wafer 11 and the CAP wafer 12 and configured to operably accommodate the operation element 21 is formed. Further, since the vent hole 23 allows communication between the operation space 13 and outside at this time, the operation space 13 is not sealed yet.

Subsequently, a heat treatment is performed at 1000°C to 1150°C for 10 minutes or more and 1 hour or less in a hydrogen gas atmosphere to cause silicon surface migration of the CAP wafer 12. In this way, as shown in FIG. 2(b), silicon undergoing surface migration 12d can flow into the through holes 23b of the vent holes 23 to close and pitch off the vent holes 23 and seal the operation space 13 (see FIG. 1(g)).

At this time, since almost all hydrogen gas flows out to the outside of the operation space 13 by a thermal diffusion phenomenon by performing the heat treatment in the hydrogen gas atmosphere having a sufficiently low hydrogen concentration, the operation space 13 is set in a high vacuum (low pressure) state.

As just described, the MEMS device manufacturing method of the embodiment of the present invention can close communication holes communicating with the operation space 13 and seal the operation space 13 by utilizing the silicon surface migration of the CAP wafer 12 by the heat treatment. In this way, a MEMS device 10 in which a sealed device is package-sealed can be manufactured.

Since a source gas or the like for epitaxial growth needs not be mixed into the hydrogen gas atmosphere at the time of the heat treatment in the MEMS device manufacturing method of the embodiment of the present invention, it is possible to leave no gas other than the hydrogen gas inside the operation space 13 after sealing and a degree of vacuum inside the operation space 13 can be enhanced after almost all the hydrogen gas flows out by the thermal diffusion phenomenon. Further, the vent holes 23 can be closed only by the heat treatment, and a simple apparatus configuration can be realized since a smaller amount of a raw material gas is used and a growth system needs not be controlled as compared to conventional techniques such as the episeal technique utilizing the epitaxial growth. Thus, the installation cost and maintenance cost of a manufacturing apparatus as well as manufacturing cost can be reduced.

Further, since the MEMS device manufacturing method of the embodiment of the present invention does not utilize the episeal technique, problems caused by a deposited epitaxial silicon layer and possible problems caused by a source gas for the epitaxial growth or the like can be avoided. Further, since a substance for closing the vent holes 23 is pure silicon and not an oxide plug or a metal plug, possible problems caused by films sealed by oxide or metal can also be avoided.

Further, since the heat treatment temperature of the heat treatment for causing the silicon surface migration is 1000°C to 1150°C and the heat treatment time is 10 minutes or more and 1 hour or less in the MEMS device manufacturing method of the embodiment of the present invention, the vent holes 23 can be closed without adversely thermally affecting the operation element 21 and the like inside the operation space 13. Further, Si surfaces of side walls and the like of the MEMS device 10 can be smoothened due to the silicon surface migration by the heat treatment.

The MEMS device manufacturing method of the embodiment of the present invention is not limited to the one in which the operation element 21 is a gyro, but may manufacture a device such as a timing resonator shown in FIG. 3, a resonator, a Lorentz-force magnetic sensor, an acceleration sensor, an IR sensor or a pressure sensor. Also in a case shown in FIG. 3, the vent holes 23 communicating with the operation space 13 can be closed and the operation space 13 can be sealed by utilizing the silicon surface migration of the CAP wafer 12 by the heat treatment, and the MEMS device 10 in which the sealed device is package-sealed can be manufactured.

It should be noted that, in the MEMS device manufacturing method of the embodiment of the present invention, the vent holes 23 may have any shape as long as at least parts thereof have such a diameter as to be closable by the surface migration due to the heat treatment. The vent holes 23 are not limited to the shape shown in FIGS. 1 and may have, for example, a tapered shape. In this case, if φ1 denotes a diameter on the inner side surface of the CAP wafer 12 on the side of the operation space 13 and φ2 denotes a diameter on the outer side surface of the CAP wafer 12 on a side opposite to the operation space 13, φ1 > φ2 or φ1 < φ2.

Further, in the MEMS device manufacturing method of the embodiment of the present invention, the thermal oxide film 11d may be formed not on the MEMS device wafer 11, but on the surface of the CAP wafer on the side of the operation space 13. In this case, the CAP wafer 12 can be bonded to the MEMS device wafer 11 by bonding the thermal oxide film of the CAP wafer 12 and the non-movable parts 22 of the MEMS device wafer 11.

Further, in the MEMS device manufacturing method of the embodiment of the present invention, the heat treatment may be performed in a hydrogen gas atmosphere containing an inert gas. In this case, the operation space 13 is set in a high vacuum (low pressure) state of the inert gas since the hydrogen gas flows out from the operation space 13 by the thermal diffusion phenomenon by the heat treatment. Thus, a degree of vacuum inside the operation space 13 can be easily adjusted by adjusting a content rate of the inert gas. In this way, the inside of the operation space 13 can be set to a degree of vacuum optimal for a function of the operation element 21. The inert gas may be any inert gas such as an Ar gas as long as the function of the operation element 21 is not adversely affected.

Further, in the MEMS device manufacturing method of the embodiment of the present invention, the vent holes 23 may be provided not in the CAP wafer 12, but in the Si substrate 11a of the MEMS device wafer 11. Also in this case, the vent holes 23 can be closed and the operation space 13 can be sealed by the silicon surface migration of the Si substrate 11a by the heat treatment.

Further, in the MEMS device manufacturing method of the embodiment of the present invention, the vent holes 23 may be provided in a bonding interface of the CAP wafer 12 and the MEMS device wafer 11. Also in this case, the vent holes 23 can be closed and the operation space 13 can be sealed by the silicon surface migration of Si single crystalline film 11b of the MEMS device wafer 11 and/or the CAP wafer 12 by heat treatment.

### Example 1

With reference to non-patent literature 1, the sealing of the vent holes 23 by the silicon surface migration was simulated while the size of the vent holes 23 and the heat treatment temperature and time were variously changed.

### [Simulation 1]

When the diameter and depth of the vent holes 23 formed in the CAP wafer 12 were set at 0.6 µm and 5 µm, the vent holes 23 could be sealed by the silicon surface migration of the CAP wafer 12 by performing the heat treatment at 1100°C for 15 minutes in a hydrogen gas atmosphere.

### [Simulation 2]

When the diameter and depth of the vent holes 23 formed in the CAP wafer 12 were set at 0.4 µm and 3 µm, the vent holes 23 could be sealed by the silicon surface migration of the CAP wafer 12 by performing the heat treatment at 1000°C for 15 minutes in a hydrogen gas atmosphere.

### [Simulation 3]

When the diameter and depth of the vent holes 23 formed in the CAP wafer 12 were set at 0.8 µm and 6 µm, the vent holes 23 could be sealed by the silicon surface migration of the CAP wafer 12 by performing the heat treatment at 1130°C for 15 minutes in a hydrogen gas atmosphere.

### [Simulation 4]

When the diameter and depth of the vent holes 23 formed in the CAP wafer 12 were set at 1 µm and 8 µm, the vent holes 23 could be sealed by the silicon surface migration of the CAP wafer 12 by performing the heat treatment at 1150°C for 15 minutes in a hydrogen gas atmosphere.

### Reference Signs List

- 10: MEMS device
- 11: MEMS device wafer
- 11a: Si substrate
- 11b: Si single crystalline film
- 11c: SiO₂ film
- 11d: thermal oxide film
- 21: operation element
- 22: non-movable part
- 12: CAP wafer
- 12a: Si substrate
- 12b: Si single crystalline film
- 12c: SiO₂ film
- 12d: silicon undergoing surface migration
- 23: vent hole
- 23a: concave cavity (inner hole)
- 23b: through hole (outer hole)
- 24: electrode region
- 13: operation space

## Claims

1. A method for manufacturing a MEMS device including a MEMS device wafer having an operation element formed on a substrate, and a CAP wafer provided to cover the MEMS device wafer to form an operation space for operably accommodating the operation element, wherein:
the CAP wafer is made of silicon and includes a vent hole formed to communicate with the operation space, and
the operation space is sealed by performing a heat treatment in a hydrogen gas atmosphere to close the vent hole by silicon surface migration of the CAP wafer with the CAP wafer and the MEMS device wafer bonded.

2. A method for manufacturing a MEMS device including a MEMS device wafer having an operation element formed on a substrate, and a CAP wafer provided to cover the MEMS device wafer to form an operation space for operably accommodating the operation element, wherein:
the substrate is made of silicon and includes a vent hole formed to communicate with the operation space, and
the operation space is sealed by performing a heat treatment in a hydrogen gas atmosphere to close the vent hole by silicon surface migration of the substrate with the CAP wafer and the MEMS device wafer bonded.

3. A method for manufacturing a MEMS device including a MEMS device wafer having an operation element formed on a substrate, and a CAP wafer provided to cover the MEMS device wafer to form an operation space for operably accommodating the operation element, wherein:
a bonding part of the MEMS device wafer with the CAP wafer and/or the CAP wafer is/are made of silicon, and
the operation space is sealed by performing a heat treatment in a hydrogen gas atmosphere to close a vent hole by silicon surface migration of the bonding part and/or the CAP wafer with the CAP wafer and the MEMS device wafer bonded and the vent hole communicating with the operation space formed in a bonding interface of the CAP wafer and the MEMS device wafer.

4. The method according to any one of claims 1 to 3 for manufacturing a MEMS device, wherein at least a part of the vent hole has such a diameter as to be closable by the surface migration.

5. The method according to any one of claims 1 to 4 for manufacturing a MEMS device, wherein the vent hole is composed of an inner hole on the operation space side and an outer hole on a side opposite to the operation space, the inner and outer holes having different diameters and communicating with each other, and φ1 > φ2 if φ1 denotes a diameter of the inner hole and φ2 denotes a diameter of the outer hole.

6. The method according to any one of claims 1 to 4 for manufacturing a MEMS device, wherein the vent hole is composed of an inner hole on the operation space side and an outer hole on a side opposite to the operation space, the inner and outer holes having different diameters and communicating with each other, and φ1 < φ2 if φ1 denotes a diameter of the inner hole and φ2 denotes a diameter of the outer hole.

7. The method according to any one of claims 1 to 4 for manufacturing a MEMS device, wherein the vent hole has a tapered shape, and φ1 > φ2 if φ1 denotes a diameter on a surface on the operation space side and φ2 denotes a diameter on a surface on a side opposite to the operation space.

8. The method according to any one of claims 1 to 4 for manufacturing a MEMS device, wherein the vent hole has a tapered shape, and φ1 < φ2 if φ1 denotes a diameter on a surface on the operation space side and φ2 denotes a diameter on a surface on a side opposite to the operation space.

9. The method according to any one of claims 1 to 8 for manufacturing a MEMS device, wherein a hydrogen gas flows out from the operation space due to thermal diffusion and the operation space is set in a vacuum state or a low pressure state by performing the heat treatment in the hydrogen gas atmosphere.

10. The method according to any one of claims 1 to 8 for manufacturing a MEMS device, wherein a hydrogen gas flows out from the operation space due to thermal diffusion and the operation space is set in a low pressure state of an inert gas by performing the heat treatment in the hydrogen gas atmosphere containing the inert gas.

11. The method according to claim 10 for manufacturing a MEMS device, wherein the inert gas is an Ar gas.

12. The method according to any one of claims 1 to 11 for manufacturing a MEMS device, wherein a heat treatment temperature of the heat treatment is 1000°C to 1150°C and a heat treatment time thereof is 10 minutes or more and 1 hour or less.

13. A MEMS device, comprising:
a MEMS device wafer having an operation element formed on a substrate; and
a CAP wafer provided to cover the MEMS device wafer to form an operation space for operably accommodating the operation element,
wherein:
each of the MEMS device wafer and the CAP wafer is constituted by an SOI wafer or a Si wafer, and
the operation space has an inner wall formed only of a material derived from the SOI wafer and/or the Si wafer and is sealed.

14. The MEMS device according to claim 13, wherein the MEMS device wafer is constituted by a SOI wafer and the operation element is formed on a Si substrate of the SOI wafer.
